(19) Europäisches Patentamt
European Patent Office
Office européen des brevets

(11) **EP 4 120 561 A1**

(12) **EUROPEAN PATENT APPLICATION**
published in accordance with Art. 153(4) EPC

(43) Date of publication:
**18.01.2023 Bulletin 2023/03**

(21) Application number: **21784476.0**

(22) Date of filing: **29.03.2021**

(51) International Patent Classification (IPC):
***H03F 1/18*** *(2006.01)*

(52) Cooperative Patent Classification (CPC):
**H03F 1/18; H03F 3/24; H03H 7/38**

(86) International application number:
**PCT/CN2021/083610**

(87) International publication number:
**WO 2021/204004 (14.10.2021 Gazette 2021/41)**

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**
Designated Extension States:
**BA ME**
Designated Validation States:
**KH MA MD TN**

(30) Priority: **10.04.2020 CN 202010281147**

(71) Applicant: **Huawei Technologies Co., Ltd.
Shenzhen, Guangdong 518129 (CN)**

(72) Inventor: **REN, Zhixiong
Shenzhen, Guangdong 518129 (CN)**

(74) Representative: **Isarpatent
Patent- und Rechtsanwälte Barth
Charles Hassa Peckmann & Partner mbB
Friedrichstrasse 31
80801 München (DE)**

(54) **SIGNAL PROCESSING METHOD AND APPARATUS**

(57) Embodiments of this application provide a signal processing method and apparatus, and relate to the communications field. In this apparatus, an isolation port of a 90° directional coupler is connected to a broadband impedance matching network, to provide an adjustable equivalent impedance part between input ports of the 90° directional coupler, so as to effectively improve efficiency of a back-off region of the signal processing apparatus.

FIG. 6

**Description**

This application claims priority to Chinese Patent Application No. 202010281147.8, filed with the China National Intellectual Property Administration on April 10, 2020, and entitled "SIGNAL PROCESSING METHOD AND APPARATUS", which is incorporated herein by reference in its entirety.

**TECHNICAL FIELD**

Embodiments of this application relate to the communications field, and in particular, to a signal processing method and apparatus.

**BACKGROUND**

Currently, an existing power amplifier (Power Amplifier, PA) mainly includes two types. One type is a load modulation power amplifier, and the other type is a bias modulation power amplifier. A load modulation technology includes two different circuit structures: a Doherty (Doherty) circuit structure and an outphasing (Outphasing) circuit structure.

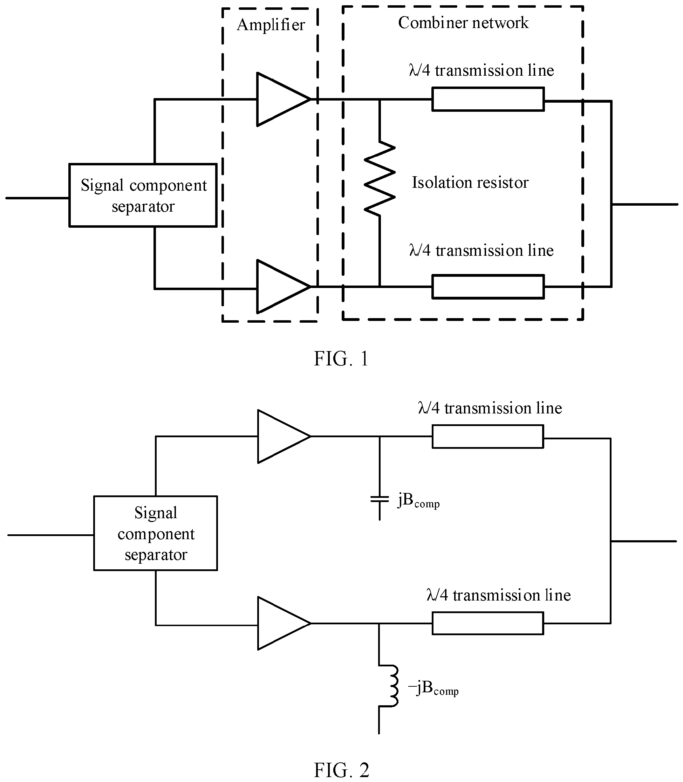

A logic and information network compiler (logic and information network compiler, LINC) combiner network is usually used in an existing outphasing system. As shown in FIG. 1, the outphasing system includes a signal component separator, two amplifiers, and a combiner network. The combiner network includes an isolation resistor and two λ/4 transmission lines. The isolation resistor is added to the combiner network, to avoid mutual impact of the two PAs, so as to obtain a better linearity characteristic. However, efficiency of a back-off region needs to be sacrificed.

**SUMMARY**

This application provides a signal processing method and apparatus, so that efficiency of a back-off region can be effectively improved.

To achieve the foregoing objectives, the following technical solutions are used in this application.

According to a first aspect, an embodiment of this application provides a signal processing apparatus, including an outphasing amplifier and a combiner matching network. Specifically, the outphasing amplifier includes a first power amplifier and a second power amplifier. The first power amplifier is configured to: in response to a received first signal, amplify the first signal, and output a first amplified signal. The second power amplifier is configured to: in response to a received second signal, amplify the second signal, and output a second amplified signal. The first amplified signal and the second amplified signal have a same frequency, and there is a phase offset. The combiner matching network includes a 90° directional coupler and a broadband impedance matching network. The 90° directional coupler includes four ports, and the four ports are respectively a first input port, a second input port, a first output port, and an isolation port. The first input port is connected to the first power amplifier, the second input port is connected to the second power amplifier, a third output port is a signal output port, and the isolation port is connected to the broadband impedance matching network. Specifically, the 90° directional coupler is configured to: in response to the first amplified signal received by using the first input port and the second amplified signal received by using the second input port, combine the first amplified signal and the second amplified signal, to obtain a third amplified signal, and output the third amplified signal through the third output port. The broadband impedance matching network includes at least one of a capacitive impedance part and an inductive impedance part, and the broadband impedance matching network is configured to provide an adjustable equivalent impedance part between the first input port and the second input port of the 90° directional coupler.

According to the method, the broadband impedance matching network is added to the isolation port of the 90° directional coupler based on a broadband characteristic of the 90° directional coupler, to provide the adjustable equivalent impedance part between input ports of the 90° directional coupler, so as to effectively improve efficiency of a back-off region.

In a possible implementation, the broadband impedance matching network is configured to provide an equivalent impedance part with a corresponding impedance value in a frequency change process of the third amplified signal.

According to the method, a required impedance value of the equivalent impedance part can be obtained by adjusting the broadband impedance matching network.

In a possible implementation, the broadband impedance matching network includes at least one capacitive impedance part and at least one inductive impedance part, the at least one capacitive impedance part and the at least one inductive impedance part are connected in series and/or in parallel, and an impedance value of the equivalent impedance part provided by the broadband impedance matching network between the first input port and the second input port changes within a predetermined range.

According to the method, the broadband impedance matching network including a capacitive impedance part and an inductive impedance part is added to the isolation port of the 90° directional coupler based on a broadband characteristic of the 90° directional coupler, and the impedance value of the equivalent impedance part of the capacitive impedance part and the inductive impedance part does not fluctuate with a frequency change of a signal, so that the apparatus can achieve a broadband characteristic while improving efficiency of a back-off region.

In a possible implementation, the broadband impedance matching network is an N-order band-pass impedance matching network, and N is an integer greater than 2.

In a possible implementation, the broadband impedance matching network includes a first impedance matching network, a second impedance matching network, and a third impedance matching network, the first impedance matching network is connected to the 90° directional coupler, the second impedance matching network is connected to the first impedance matching network, and the third impedance matching network is connected to the second impedance matching network. The first impedance matching network includes a capacitive impedance part and an inductive impedance part that are connected in parallel, and a resonance frequency of the first impedance matching network is equal to a center frequency of a preset bandwidth. The second impedance matching network includes a capacitive impedance part and an inductive impedance part that are connected in series, and a resonance frequency of the second impedance matching network is greater than the center frequency. The third impedance matching network includes a capacitive impedance part and an inductive impedance part that are connected in parallel, and a resonance frequency of the third impedance matching network is equal to any frequency within the preset bandwidth.

According to the method, an impedance part of the broadband impedance matching network may be adjusted based on a design rule of this application, so that the equivalent impedance part meets a broadband requirement.

In a possible implementation, a phase difference between the first amplified signal and the second amplified signal is 90°.

In a possible implementation, a relative bandwidth of the third amplified signal is greater than or equal to 70%.

According to the method, a broadband characteristic that the relative bandwidth is at least 70% can be implemented in this application.

According to a second aspect, an embodiment of this application provides a signal processing method. The method is applied to a signal processing apparatus, and the signal processing apparatus includes an outphasing amplifier and a combiner matching network. The method includes: In response to a received first signal, the outphasing amplifier amplifies the first signal, and outputs a first amplified signal. In response to a received second signal, the outphasing amplifier amplifies the second signal, and outputs a second amplified signal. The first amplified signal and the second amplified signal have a same frequency, and there is a phase offset. In response to the first amplified signal received by using a first input port and the second amplified signal received by using a second input port, the combiner matching network combines the first amplified signal and the second amplified signal, to obtain a third amplified signal, and outputs the third amplified signal. The combiner matching network includes a 90° directional coupler and a broadband impedance matching network, the broadband impedance matching network includes at least one of a capacitive impedance part and an inductive impedance part, and the broadband impedance matching network provides an adjustable equivalent impedance part between the first input port and the second input port of the 90° directional coupler.

In a possible implementation, the broadband impedance matching network is configured to provide an equivalent impedance part with a corresponding impedance value in a frequency change process of the third amplified signal.

In a possible implementation, the broadband impedance matching network includes at least one capacitive impedance part and at least one inductive impedance part, the at least one capacitive impedance part and the at least one inductive impedance part are connected in series and/or in parallel, and an impedance value of the equivalent impedance part provided by the broadband impedance matching network between the first input port and the second input port changes within a predetermined range.

In a possible implementation, the broadband impedance matching network is an N-order band-pass impedance matching network, and N is an integer greater than 2.

In a possible implementation, the broadband impedance matching network includes a first impedance matching network, a second impedance matching network, and a third impedance matching network, the first impedance matching network is connected to the 90° directional coupler, the second impedance matching network is connected to the first impedance matching network, and the third impedance matching network is connected to the second impedance matching network. The first impedance matching network includes a capacitive impedance part and an inductive impedance part that are connected in parallel, and a resonance frequency of the first impedance matching network is equal to a center frequency of a preset bandwidth. The second impedance matching network includes a capacitive impedance part and an inductive impedance part that are connected in series, and a resonance frequency of the second impedance matching network is greater than the center frequency. The third impedance matching network includes a capacitive impedance part and an inductive impedance part that are connected in parallel, and a resonance frequency of the third impedance matching network is equal to any frequency within the preset bandwidth.

In a possible implementation, a phase difference between the first amplified signal and the second amplified signal is 90°.

In a possible implementation, a relative bandwidth of the third amplified signal is greater than or equal to 70%.

According to a third aspect, an embodiment of this application provides a chip, where the chip includes a processor and transceiver pins. The transceiver pins and the processor communicate with each other through an internal connection path. The processor performs the method in any one of the second aspect or the possible implementations of the second aspect, to control a receive pin to receive a signal and control a transmit pin to send a signal.

According to a fourth aspect, an embodiment of this application provides a computer-readable medium, configured to store a computer program. The computer program includes instructions used to perform the method in any one of the second aspect or the possible implementations of the second aspect.

According to a fifth aspect, an embodiment of this application provides a computer program. The computer program includes instructions used to perform the method in any one of the second aspect or the possible implementations of the second aspect.

According to a sixth aspect, an embodiment of this application provides a signal processing system. The system includes the apparatus in any one of the first aspect or the possible implementations of the first aspect.

**BRIEF DESCRIPTION OF DRAWINGS**

To describe the technical solutions in embodiments of this application more clearly, the following briefly describes the accompanying drawings used in describing embodiments of this application. It is clear that the accompanying drawings in the following descriptions show merely some embodiments of this application, and a person of ordinary skill in the art may still derive other drawings from these accompanying drawings without creative efforts.

FIG. 1 is a schematic diagram of a structure of an example outphasing system;
FIG. 2 is a schematic diagram of a structure of an example outphasing system;
FIG. 3 is a schematic diagram of a structure of an example outphasing system;
FIG. 4 is a schematic diagram of a structure of an example outphasing system;
FIG. 5 is a schematic diagram of a structure of an example outphasing system;
FIG. 6 is a schematic diagram of a structure of a signal processing system according to an embodiment of this application;
FIG. 7 is a schematic diagram of a structure of an example 90° directional coupler;
FIG. 8 is a schematic diagram of a structure of a signal processing system according to an embodiment of this application;
FIG. 9 is a schematic diagram of a structure of a signal processing system according to an embodiment of this application;
FIG. 10 is a schematic diagram of a structure of an example equivalent signal processing system;
FIG. 11 is a diagram of an example impedance change trend;
FIG. 12 shows an example efficiency simulation result;
FIG. 13 is a schematic diagram of a structure of a signal processing system according to an embodiment of this application;
FIG. 14 is a schematic diagram of a broadband impedance matching network according to an embodiment of this application;
FIG. 15 shows an example efficiency simulation result in different frequency ranges;
FIG. 16 is a schematic diagram of a broadband impedance matching network according to an embodiment of this application;
FIG. 17 shows an example efficiency simulation result in different frequency ranges;
FIG. 18 is a schematic diagram of a broadband impedance matching network according to an embodiment of this application;
FIG. 19a is a diagram of an example impedance change trend;
FIG. 19b is a diagram of an example impedance change trend; and
FIG. 19c is a diagram of an example impedance change trend.

**DESCRIPTION OF EMBODIMENTS**

The following clearly and completely describes the technical solutions in embodiments of this application with reference to the accompanying drawings in embodiments of this application. It is clear that the described embodiments are some but not all of embodiments of this application. All other embodiments obtained by a person of ordinary skill in the art based on embodiments of this application without creative efforts shall fall within the protection scope of this application.

The term "and/or" in this application describes only an association relationship between associated objects and indicates that three relationships may exist. For example, A and/or B may indicate the following three cases: Only A exists, both A and B exist, and only B exists.

In the specification and claims in embodiments of this application, the terms "first", "second", and the like are intended to distinguish between different objects but do not indicate a specific order of the objects. For example, a first target object, a second target object, and the like are used to distinguish different target objects, but are not used to describe a specific order of the target objects.

In embodiments of this application, the word "example" or "for example" is used to represent giving an example, an illustration, or a description. Any embodiment or design scheme described as "in an example" or "for example" in embodiments of this application should not be explained as being more preferred or having more advantages than another embodiment or design scheme. Exactly, use of the word "example" or "for example" or the like is intended to present a relative concept in a specific manner.

In the descriptions of embodiments of this application, unless otherwise stated, "a plurality of" means two or more than two. For example, a plurality of processing units refer to two or more processing units; and a plurality of systems refer to two or more systems.

To enable a person skilled in the art to better understand the technical solutions in embodiments of this application, a conventional technology is first described.

FIG. 2 is a schematic diagram of an example outphasing structure in the conventional technology. Specifically, FIG. 2 shows a Chireix (Chireix) combiner-based outphasing structure. The following briefly describes a principle of an outphasing technology with reference to FIG. 2.

When an input signal is a signal on which both amplitude modulation and phase modulation are performed, the signal is separated into two constant-envelope phase-modulated signals by a signal component separator (signal component separator, SCS). Amplitude information of the original input signal is included in phase information of the two separated signals.

The two constant-envelope signals are amplified by using two PAs. Because amplitudes of the signals are constant, an efficient PA with a nonlinear power may be used to amplify the signals without causing distortion, to ensure linearity of the signals, and use the efficient PA.

Finally, the two amplified phase-modulated signals are combined to restore the original amplitude-modulated and phase-modulated signal.

The obtaining of the original signal is affected by a phase difference between the two signals. Because phases of the two signals are different, the combination is outphasing combination, namely, outphasing combination. Therefore, loads of the two PAs are dynamic loads affected by the signal phases.

It can be learned from the foregoing descriptions that the core of the concept of outphasing amplification is to convert an amplitude-modulated and phase-modulated signal into two constant-envelope signals, amplify the signals by using an efficient nonlinear PA, and restore the original signal by combining the two signals. This process is that shown in FIG. 2.

The process includes: An input signal $S_{in}(t)$ is separated into two signals $S_1(t)$ and $S_2(t)$. Details are as follows:

$$S_{in}(t) = A(t) \times \cos(\omega t + \varphi(t))$$

A(t) is an amplitude-modulated signal, $\varphi(t)$ is a phase-modulated signal, and $\omega$ is a carrier frequency.

The signals $S_1(t)$ and $S_2(t)$ obtained after separation are represented as follows:

$$S_1(t) = A_0 \times \cos(\omega t + \varphi(t) + \theta(t))$$

$$S_2(t) = A_0 \times \cos(\omega t + \varphi(t) - \theta(t))$$

$A_0 = \max(abs(A(t)))$, and $\theta(t) = \arccos(0.5 \times A(t)/A_0)$. It can be learned according to the formulas that a phase difference between the two signals $S_1(t)$ and $S_2(t)$ is $2\theta(t)$.

Subsequently, $S_1(t)$ and $S_2(t)$ are respectively amplified by the two PAs, and then are combined into an output signal $S_{out}(t)$ by a combiner. Details are as follows:

$$S_{out}(t) = G_{PA} \times [S_1(t) + S_2(t)] = G_{PA} \times A(t) \times \cos(\omega t + \varphi(t))$$

$G_{PA}$ is a gain value of a PA.

To be specific, $S_1(t)$ and $S_2(t)$ are amplified by an efficient switching power amplifier (for example, a class-D power amplifier or a class-E power amplifier), and the two signals are combined on an output port of the amplifier, to restore the original signal without causing a loss on linearity. Theoretical efficiency is 100%. An output combiner network in a conventional outphasing technology is usually a high-isolation LINC combiner network and a low-isolation Chireix combiner network. In this specification, only the Chireix combiner network is described. Specifically, with reference to FIG. 2, the Chireix combiner network includes a capacitive impedance part $jB_{comp}$ and an inductive impedance part $-jB_{comp}$. In the Chireix combiner network, a load modulation effect between the two PAs is used to obtain a better efficiency characteristic while sacrificing linearity of the PA. Further, a $\lambda/4$ transmission line is used for the Chireix combiner network, and it is difficult to satisfy a high-efficiency characteristic of outphasing while covering a wide frequency range.

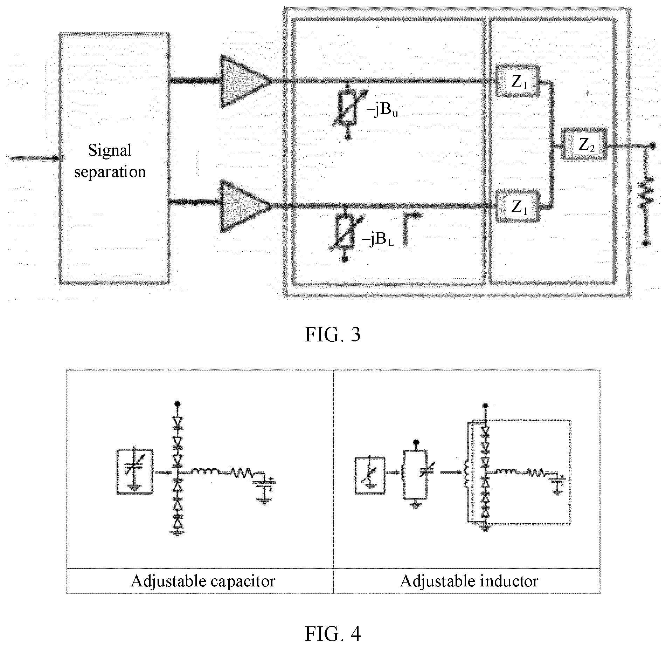

FIG. 3 shows an example broadband outphasing system. As shown in FIG. 3, in this solution, a conventional signal component separator, two amplifiers, and a combiner network are used. In this system, a Chireix combiner network is improved. The Chireix combiner network includes an adjustable capacitor ($jB_U$), an inductor ($-jB_L$), and transmission lines ($Z_1$ and $Z_2$). In the Chireix combiner network, a compensation network is designed to include a voltage-adjustable capacitor ($jB_U$) and a voltage-adjustable inductor ($-jB_L$), so that the compensation network can be adjusted at different frequencies. In addition, the corresponding compensation network may be used to improve efficiency of a back-off region at different frequencies. An implementation solution of the adjustable capacitor and the adjustable inductor is shown in FIG. 4. A core device is a variable capacitance diode.

In this solution, the adjustable capacitor and the adjustable inductor are used to adjust the compensation network, to change an original passive Chireix combiner (namely, the Chireix combiner network in FIG. 2) into an active device. Consequently, complexity of an output network is increased. Correspondingly, in this solution, a control voltage generation circuit needs to be newly added, and consequently, complexity of an overall transmitter is increased. Because the variable capacitance diode is added to the output network, an output power of an outphasing PA is limited by a voltage withstand capability of the variable capacitance diode instead of a power transistor. Consequently, feasibility of the solution in a high power scenario is limited.

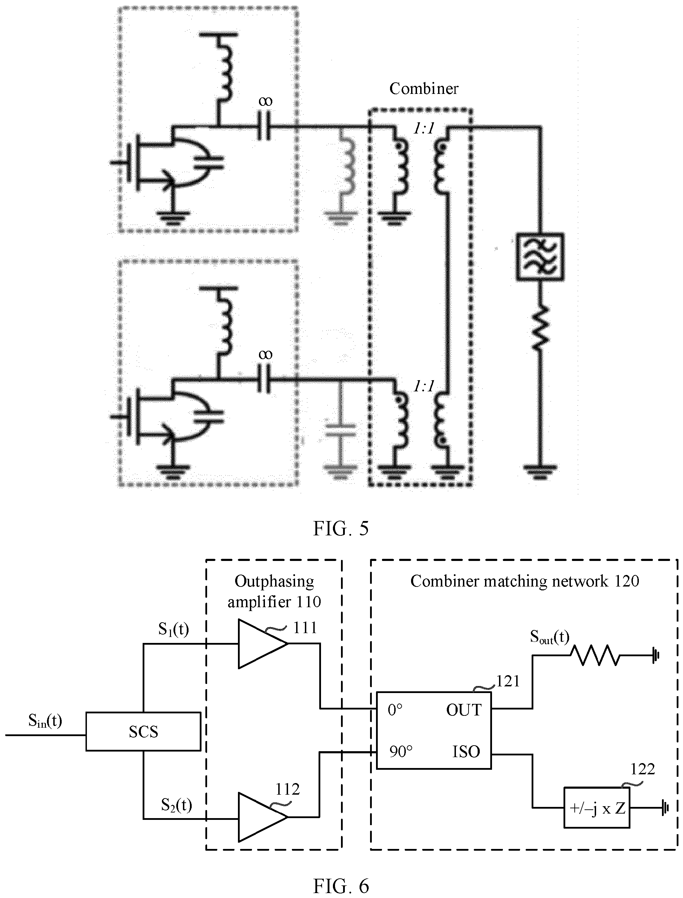

FIG. 5 shows another example broadband outphasing system. As shown in FIG. 5, in this solution, structure of a conventional Chireix combiner is improved. A $\lambda/4$ transmission line is replaced based on a bandwidth characteristic of a transformer, to implement a broadband Chireix combiner network. Although efficiency is improved in an over 10 dB back-off region, limited by resonance frequencies of compensation networks $L\theta c$ and $C\theta c$, a frequency range in which the Chireix combiner network may operate finally is 2.1 GHz to 2.4 GHz, and a relative bandwidth is less than 15%.

For the foregoing problems, this application provides the outphasing system. A capacitive impedance part or an inductive impedance part is connected to an isolation port of a 90° directional coupler based on a phase characteristic of the 90° directional coupler, so that an equivalent device of an inductive device and a capacitive device is provided between two input ports of the 90° directional coupler, to realize a function of a conventional outphasing system, so as to improve efficiency of a back-off region. In addition, in this application, a broadband impedance matching network including a capacitive impedance part and an inductive impedance part is connected to an isolation port of a 90° directional coupler based on a broadband characteristic of the 90° directional coupler, to implement the broadband characteristic while increasing frequency of a 5 dB back-off region.

FIG. 6 is a schematic diagram of a structure of a signal processing system according to an embodiment of this application. As shown in FIG. 6, specifically, a signal processing system 100 includes but is not limited to an outphasing amplifier 110 and a combiner matching network 120. Optionally, the signal processing system 100 further includes a signal component separator. For a function of the signal component separator, refer to descriptions in FIG. 2. Details are not described herein again.

For example, the outphasing amplifier 110 includes two power amplifiers, and the two power amplifiers are respectively a power amplifier 111 and a power amplifier 112. The two power amplifiers are configured to: amplify an input signal, and output two amplified signals, namely, $S_1(t)$ and $S_2(t)$. For a specific structure and an implementation principle of the outphasing amplifier, refer to the foregoing descriptions. Details are not described herein again.

Still refer to FIG. 6. The combiner matching network 120 in this application includes a 90° directional coupler 121 and a broadband impedance matching network 122.

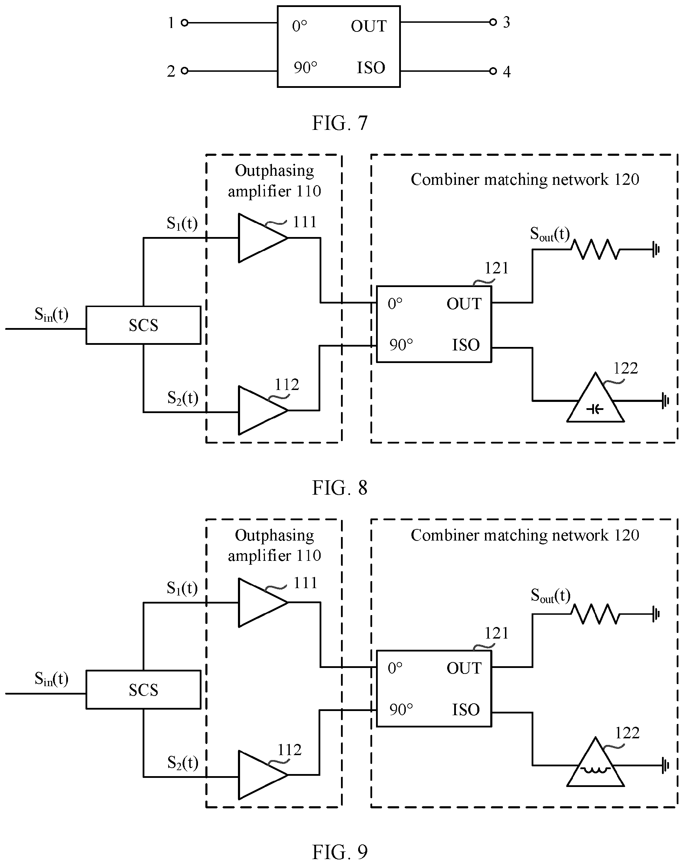

Specifically, the 90° directional coupler 121 is a four-port device. FIG. 7 is a schematic diagram of a structure of a 90° directional coupler. The 90° directional coupler includes a port 1, a port 2, a port 3, and a port 4. In this application, the port 1 and the port 2 are input ports, and are configured to be connected to the outphasing amplifier 110. For example, the port 1 is connected to the power amplifier 111, and the port 2 is connected to the power amplifier 112. Still referring to FIG. 7, a transmission line penetrating through the port 1 and the port 3 and a transmission line penetrating through the port 2 and the port 4 may be considered as two straight-through and coupled transmission lines, and the lines perform energy interaction with each other based on a specific coupling mechanism, including a hole-coupling mechanism, a branch coupling mechanism, a parallel coupling mechanism, a matched double T coupling mechanism, or the like. When a signal is input from the port 1 and the port 2, the port 3 can output energy as an output port. For example, in this application, the port 4 is an isolation (Isolation, ISO) port.

Specifically, for a device of the 90° directional coupler, a phase difference between input signals needs to be 90°. In other words, a phase difference between $S_1(t)$ and $S_2(t)$ is 90°. In this application, two signals processed by the outphasing amplifier may be represented as follows:

$$S_1(t) = A_0 \text{ x } \cos(\omega t + \varphi(t) + \theta(t))$$

$$S_2(t) = A_0 \text{ x } \sin(\omega t + \varphi(t) - \theta(t))$$

In other words, a phase difference between the two signals $S_1(t)$ and $S_2(t)$ obtained after separation is 90°.

Specifically, in order that the phase difference between the two signals is 90°, for example, phases of the two signals obtained after separation may be processed before the two signals are input into the two amplifiers, so that the two signals meet a requirement that the phase difference is 90°. For example, phases of the two signals may alternatively be processed after the two amplifiers amplify the two signals and before the two signals are input into the 90° directional coupler. This is not limited in this application.

With reference to FIG. 7, in this application, the port 1 of the 90° directional coupler 121 may receive the signal $S_1(t)$ output by the power amplifier 111, the port 2 may receive the signal $S_2(t)$ output by the power amplifier 112, the 90° directional coupler 121 combines the two signals to obtain an output signal $S_{out}(t)$, and outputs the output signal through an output port, for example, the port 3 in FIG. 7. Optionally, the output port is grounded by using a load.

Still refer to FIG. 6. In this application, an isolation port of the 90° directional coupler 121 is connected to a broadband impedance matching circuit 120. In an example, the broadband impedance matching network may be a capacitive impedance part, which is alternatively referred to as a capacitive impedance network. For example, the broadband impedance matching network may include one or more capacitive devices, for example, may include one or more capacitors. For example, as shown in FIG. 8, the broadband impedance matching network 122 is a capacitive impedance part. In another example, the broadband impedance matching network may be an inductive impedance part, which is alternatively referred to as an inductive impedance circuit. For example, the broadband impedance matching network may include one or more inductive devices, for example, may include one or more inductors. For example, as shown in FIG. 9, the broadband impedance matching network 122 is an inductive impedance part.

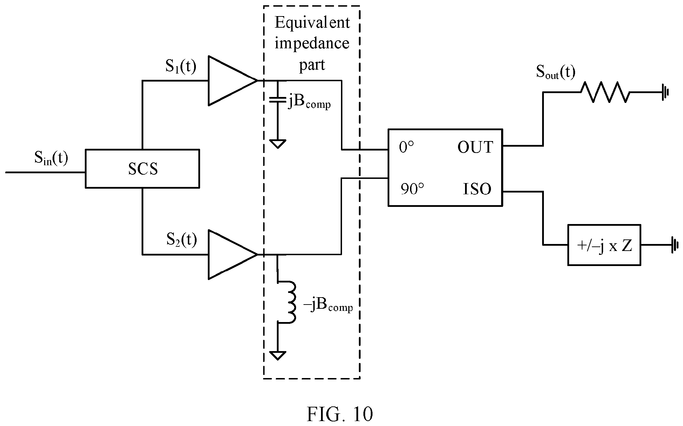

Specifically, in this application, when the broadband impedance matching circuit 120 includes a capacitive impedance part or an inductive impedance part, the broadband impedance matching circuit is terminated to the isolation port of the 90° directional coupler 121. Based on a broadband characteristic of the 90° directional coupler 121, it is equivalent to providing an adjustable equivalent impedance part between two input ports of the 90° directional coupler 121, namely, the port 1 and the port 2 in FIG. 7. For example, an equivalent impedance part of an inductor ($jB_{comp}$) and a capacitor ($-jB_{comp}$) may be provided between the two input ports. An equivalent diagram is shown in FIG. 10. An equivalent impedance part of the capacitive impedance part and inductive impedance part may be referred to as a capacitor-inductor (LC) compensation network.

As described above, based on a characteristic that an input phase difference of the 90° directional coupler 121 is 90°, it can be learned based on the following formula that an equivalent compensation phase of the equivalent LC compensation network is equal to 45°.

$$\eta = \frac{2sin^2(\theta)}{\sqrt{[2sin^2(\theta)]^2 + [sin(2\theta) - sin(2\theta_C)]^2}}$$

Herein, $\eta$ is peak efficiency, $\theta_C$ (the equivalent compensation phase) is 45°, $\theta$ is a phase difference between the two signals. In other words, in this application, a function of the LC compensation network (namely, the system shown in FIG. 2) in a conventional Chireix structure may be realized. To be specific, an equivalent impedance value can be optimal at a specific frequency, for example, 14 GHz.

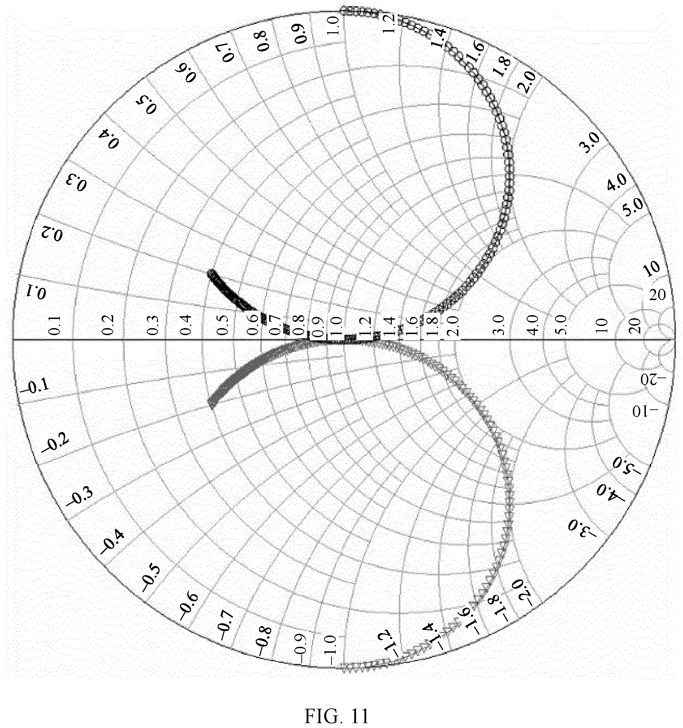

FIG. 11 is a diagram of an impedance change trend corresponding to FIG. 8 or FIG. 9. FIG. 11 shows a status in which two impedance parts change with a phase. An outphasing system in this embodiment is equivalent to a conventional Chireix combiner-based outphasing system in FIG. 2. Referring to FIG. 11, an equivalent impedance curve including an upper/lower semicircle in a Smith chart. The upper/lower semicircle each represents an impedance curve of positive/negative reactance.

In an example, if the broadband impedance matching network is a capacitive impedance part, as shown in FIG. 8, with reference to FIG. 11, 0° equivalent input impedance is in the lower semicircle on the Smith chart, and 90° equivalent input impedance is in the upper semicircle on the Smith chart.

In another example, if the broadband impedance matching network is an inductive impedance part, as shown in FIG. 9, with reference to FIG. 11, 0° equivalent input impedance is in the upper semicircle on Smith chart, and 90° equivalent input impedance is in the lower semicircle on the Smith chart.

It can be learned from FIG. 11 that when the equivalent compensation phase $\theta_C$ is equal to 45°, the impedance curves of the positive reactance and the negative reactance intersect at a point. In other words, imaginary parts are 0, and real parts are equal.

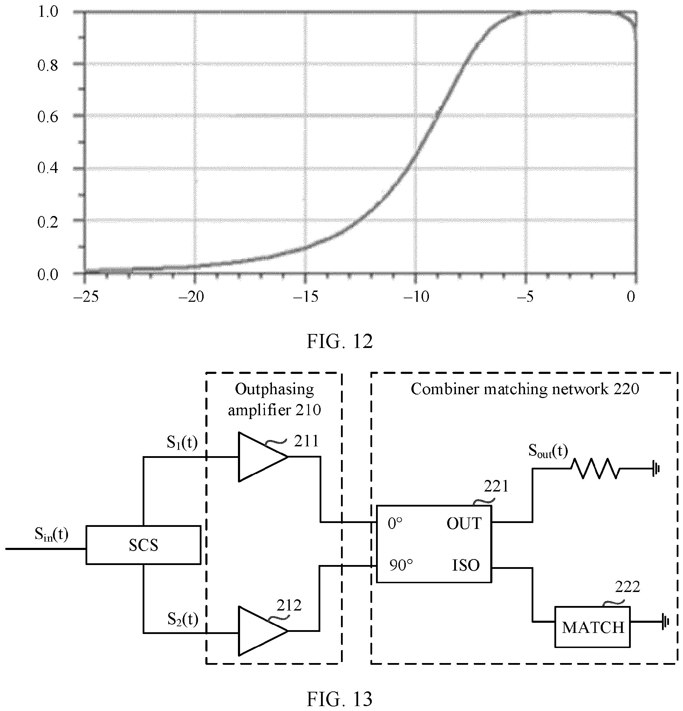

FIG. 12 shows a simulation result of efficiency of an output signal of a system. Referring to FIG. 12, the simulation result is obtained by performing simulation based on an ideal voltage source and scanning the phase difference between the two signals. A horizontal axis represents a normalized relative output power (a unit is dB), and a vertical axis represents output efficiency. It can be learned from the figure that, in a 5 dB back-off region, the efficiency of the output signal of the system still has a highest value, in other words, is basically the same as an efficiency value corresponding to a highest output power. Therefore, the signal processing system in this application can improve efficiency of the 5 dB back-off region.

FIG. 13 is a schematic diagram of a structure of a signal processing system according to an embodiment of this application. As shown in FIG. 13, specifically, a signal processing system 200 includes but is not limited to an outphasing amplifier 210 and a combiner matching network 220.

For related descriptions of the outphasing amplifier 120, refer to descriptions of the foregoing outphasing amplifier 110. Details are not described herein again.

The following describes the combiner matching network 220 in detail.

Specifically, the combiner matching network 220 includes but is not limited to a 90° directional coupler 221 and a broadband impedance matching network 222. For a related concept of the 90° directional coupler 221, refer to the 90° directional coupler 121 in the foregoing descriptions. Details are not described herein again.

Specifically, based on an outphasing system shown in FIG. 6, in this application, a band-pass impedance matching network, which may alternatively be referred to as a band-pass filter network, may be terminated to an isolation port of the 90° directional coupler 221 based on a broadband characteristic of the 90° directional coupler 221. An adjustable equivalent impedance part may be provided between two input ports of the 90° directional coupler 211. For example, an equivalent impedance part of a capacitive impedance part and an inductive impedance part may be provided between the two input ports, and a structure of the matching network is adjusted based on an impedance value of the equivalent impedance part of the capacitive impedance part and the inductive impedance part, to implement a broadband characteristic of the outphasing system.

For example, in this embodiment, the broadband impedance matching network 222 includes at least one inductive impedance part and at least one capacitive impedance part. In an example, the at least one inductive impedance part and the at least one capacitive impedance part are connected in series. In another example, the at least one inductive impedance part and at least one capacitive impedance part are connected in parallel. In still another example, the broadband impedance matching network 222 includes the at least one inductive impedance part and the at least one capacitive impedance part that are connected in series and the at least one inductive impedance part and the at least one capacitive impedance part that are connected in parallel. For example, in this application, at least one inductive impedance part and at least one capacitive impedance part form the band-pass impedance matching network.

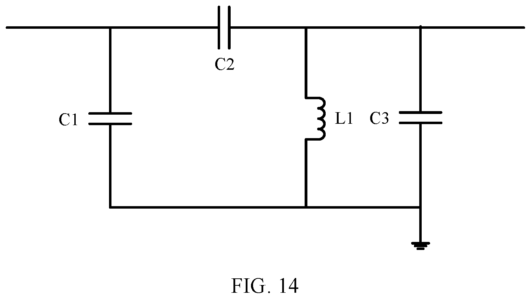

In an example, FIG. 14 is a schematic diagram of an example band-pass impedance matching network. Referring to FIG. 14, the band-pass impedance matching network includes an inductive impedance part L1, a capacitive impedance part C1, and a capacitive impedance part C3 that are connected in parallel, and a capacitive impedance part C2 and an inductive impedance part L3 that are connected in series.

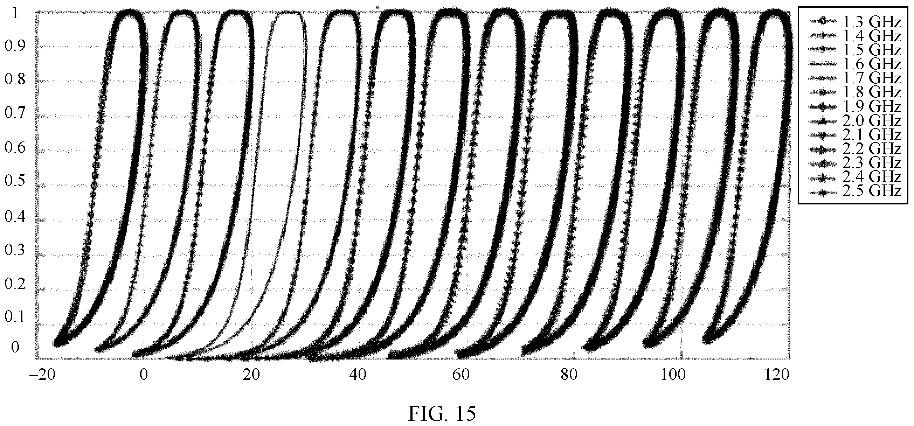

FIG. 15 shows a simulation result of efficiency of an outphasing system based on the band-pass impedance matching network in FIG. 14 in different frequency ranges. The simulation result is obtained by performing simulation based on an ideal voltage source and scanning a phase difference between two signals. FIG. 15 is a diagram of a simulation result of efficiency in a frequency range of 1.3 GHz to 2.5 GHz. In the figure, from left to right, 1.3 GHz, 1.4 GHz, 1.5 GHz, 1.6 GHz, 1.7 GHz, 1.8 GHz, 1.9 GHz, 2.0 GHz, 2.1 GHz, 2.2 GHz, 2.3 GHz, 2.4 GHz, and 2.5 GHz each are used as an example for description. In FIG. 15, a horizontal axis represents a normalized relative output power (a unit is dB), and a vertical axis represents output efficiency. It can be learned from the figure that, within a frequency coverage range of 1.3 GHz to 2.5 GHz, an efficiency value in a 5 dB back-off region is basically the same as an efficiency value corresponding to the highest output power. In other words, for a signal with a bandwidth of 1.2 GHz, a relative bandwidth is 70%. After the signal is processed by the outphasing system based on the band-pass impedance matching network in FIG. 14, 5 dB back-off efficiency can be implemented. In other words, in this application, a broadband characteristic that the relative bandwidth is 70% can be implemented while implementing the 5 dB back-off region.

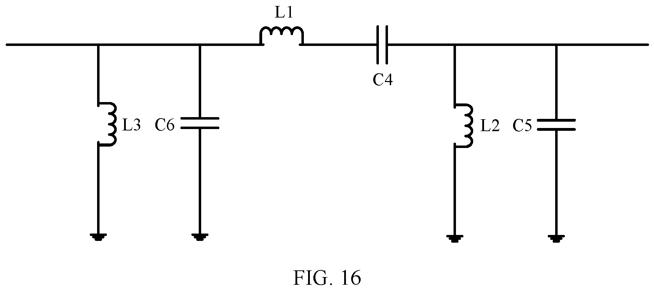

In another example, FIG. 16 is a schematic diagram of another example band-pass impedance matching network. Referring to FIG. 16, the band-pass impedance matching network includes an inductive impedance part L2, a capacitive impedance part C5, a capacitive impedance part C6, and an inductive impedance part L3 that are connected in parallel, and an inductive impedance part L1 and a capacitive impedance part C4 that are connected in series.

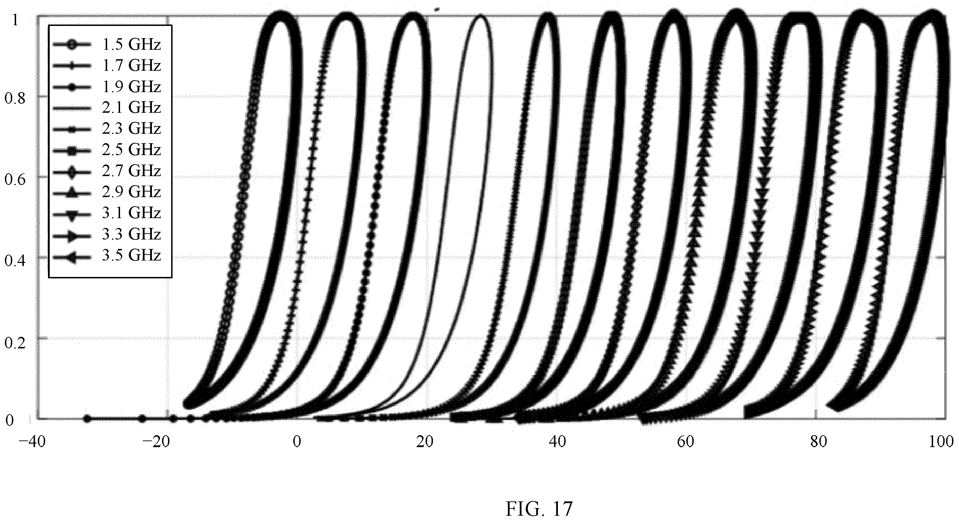

FIG. 17 shows a simulation result of efficiency of an outphasing system based on the band-pass impedance matching network in FIG. 16 in different frequency ranges. The simulation result is obtained by performing simulation based on an ideal voltage source and scanning a phase difference between two signals. FIG. 17 is a diagram of a simulation result of efficiency in a frequency range of 1.5 GHz to 3.5 GHz. In the figure, from left to right, 1.5 GHz, 1.7 GHz, 1.9 GHz, 2.1 GHz, 2.3 GHz, 2.5 GHz, 2.7 GHz, 2.9 GHz, 3.1 GHz, 3.3 GHz, and 3.5 GHz each are used as an example for description. In FIG. 17, a horizontal axis represents a normalized relative output power (a unit is dB), and a vertical axis represents output efficiency. It can be learned from the figure that, within a frequency coverage range of 1.5 GHz to 3.5 GHz, an efficiency value in a 5 dB back-off region is basically the same as an efficiency value corresponding to the highest output power. In other words, for a signal with a bandwidth of 2.0 GHz, after the signal is processed by the outphasing system based on the band-pass impedance matching network in FIG. 16, 5 dB back-off efficiency can be implemented. In other words, in this application, a broadband characteristic that the relative bandwidth is 80% can be implemented while implementing the 5 dB back-off region.

It should be noted that, based on different band-pass impedance matching networks, coverage frequencies, namely, relative bandwidths, of the outphasing system are the same or different.

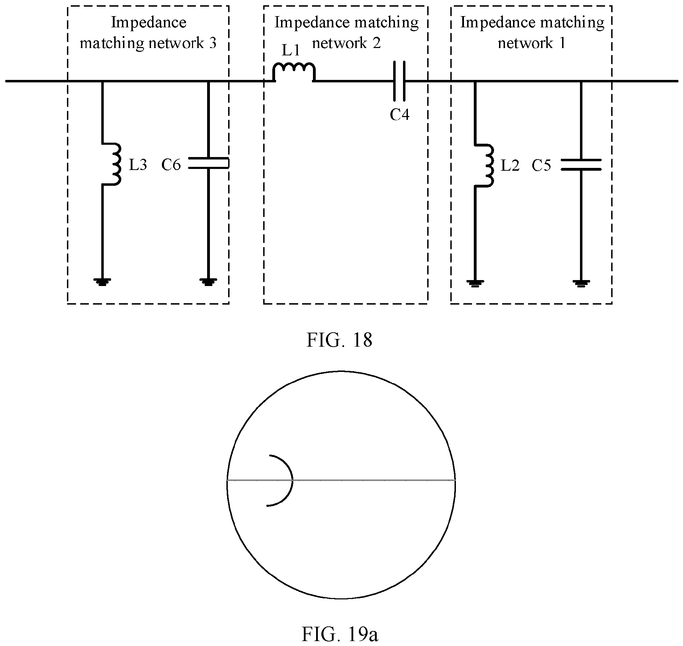

A design principle of the band-pass impedance matching network in this application is mainly that impedance of the band-pass impedance matching network does not change with a frequency of a signal. The following describes the design principle in detail. The band-pass impedance matching network shown in FIG. 16 is used as an example. Referring to FIG. 18, details are as follows:

(1) An impedance matching network 1 is configured.

Specifically, referring to FIG. 18, the impedance matching network 1 includes a parallel LC network. To be specific, the inductive impedance part L2 and the capacitive impedance part C5 are connected in parallel. When the LC network is configured, a resonance point that is of the LC network and that is at a center frequency of a required bandwidth is selected. For example, in this embodiment, as described above, if the coverage frequency is 1.5 GHz to 3.5 GHz, a resonance frequency of the LC network is equal to 2.5 GHz. FIG. 19a to FIG. 19c each are a diagram of an impedance change trend. The impedance change trend may be considered as an impedance change trend of an LC network equivalent to the 90° directional coupler. The impedance change trend shows an impedance change status of an equivalent impedance part existing after the matching network is transformed. Specifically, an equivalent impedance value corresponding to the impedance matching network 1 is shown by a curve in FIG. 19a in a Smith chart.

(2) An impedance matching network 2 is configured.

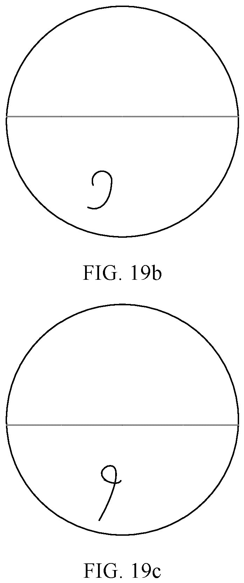

Specifically, referring to FIG. 18, the impedance matching network 2 includes a series LC network. To be specific, the inductive impedance part L1 and the capacitive impedance part C4 are connected in series. When the LC network is configured, a resonance frequency that is of the LC network and that is much greater than a required coverage frequency range of 1.5 GHz to 3.5 GHz, for example, 3 x 3.5 GHz is selected, to move an impedance value, namely, the curve shown in FIG. 19a, so that the curve rotates counterclockwise along an impedance circle in the Smith chart and radian of the curve is reduced. In other words, after the impedance matching network 2 is added, an equivalent impedance value is moved to be close to a predetermined impedance value. For example, the predetermined impedance value may be -j $\times$ 50 $\Omega$. After the impedance matching network 2 is added, for example, the curve in FIG. 19a may be moved toward -j $\times$ 50 $\Omega$, to be close to -j $\times$ 35 $\Omega$. A decrease in the radian of the impedance curve may be understood as a decrease in fluctuation of a change of the equivalent impedance with frequency of a signal. In other words, as shown in FIG. 19b, fluctuation of the equivalent impedance value is small in a frequency change process of the signal.

(3) An impedance matching network 3 is configured.

Specifically, referring to FIG. 18, the impedance matching network 3 includes a parallel LC network. To be specific, the inductive impedance part L3 and the capacitive impedance part C6 are connected in parallel. When the LC network is configured, a resonance frequency that is of the LC network and that is within the required coverage frequency range, namely, 1.5 GHz to 3.5 GHz, for example, 2.5 GHz is selected, to further reduce radian of a curve in FIG. 19b, in other words, to further reduce impedance fluctuation. It can be understood that, in the frequency change process of the signal, a fluctuation range of equivalent impedance is less than a fluctuation range in FIG. 19b. In other words, an objective of this application is that the equivalent impedance does not change (or fluctuate) with a frequency change of the signal. Alternatively, the equivalent impedance only fluctuates with the frequency change of the signal within a small range, for example, within a range of -j $\times$ 50 $\Omega$ $\pm$ 5 $\Omega$, as shown in FIG. 19c. It should be noted that Smith charts in FIG. 19a to FIG. 19c are simplified charts, and reference may be made to the Smith chart in FIG. 11.

Based on a same technical concept, an embodiment of this application further provides a signal processing apparatus, configured to perform the foregoing method embodiment.

Based on a same technical concept, an embodiment of this application further provides a chip, where the chip includes a processor and transceiver pins. The transceiver pins and the processor communicate with each other through an internal connection path. The processor is configured to perform the foregoing method embodiment, to control a receive pin to receive a signal and control a transmit pin to send a signal.

Based on a same technical concept, an embodiment of this application further provides a computer-readable medium, configured to store a computer program, where the computer program includes instructions used to perform the foregoing method embodiment.

Based on a same technical concept, an embodiment of this application further provides a computer program, where the computer program includes instructions used to perform the foregoing method embodiment.

Based on a same technical concept, an embodiment of this application further provides a signal processing system. The signal processing system may include the apparatus described in this application.

Embodiments of this application are described above with reference to the accompanying drawings. However, this application is not limited to the foregoing specific implementations. The foregoing specific implementations are merely examples rather than limitations. A person of ordinary skill in the art, under the teachings of this application, may further make many modifications without departing from the purposes of this application and the protection scope of the claims, and all the modifications shall fall within the protection of this application.

**Claims**

1. A signal processing apparatus, comprising an outphasing amplifier and a combiner matching network, wherein the outphasing amplifier comprises:

   a first power amplifier, configured to: in response to a received first signal, amplify the first signal, and output a first amplified signal; and
   a second power amplifier, configured to: in response to a received second signal, amplify the second signal, and output a second amplified signal, wherein the first amplified signal and the second amplified signal have a same frequency, and there is phase offset; and
   the combiner matching network comprises a 90° directional coupler and a broadband impedance matching network, wherein
   the 90° directional coupler comprises a first input port, a second input port, a first output port, and an isolation port, the first input port is connected to the first power amplifier, the second input port is connected to the second power amplifier, and a third output port is a signal output port;
   the 90° directional coupler is configured to: in response to the first amplified signal received by using the first input port and the second amplified signal received by using the second input port, combine the first amplified signal and the second amplified signal, to obtain a third amplified signal, and output the third amplified signal through the third output port; and
   the broadband impedance matching network is connected to the isolation port, the broadband impedance matching network comprises at least one of a capacitive impedance part and an inductive impedance part, and the broadband impedance matching network is configured to provide an adjustable equivalent impedance part between the first input port and the second input port of the 90° directional coupler.

2. The apparatus according to claim 1, wherein the broadband impedance matching network is configured to provide an equivalent impedance part with a corresponding impedance value in a frequency change process of the third amplified signal.

3. The apparatus according to claim 2, wherein the broadband impedance matching network comprises at least one capacitive impedance part and at least one inductive impedance part, the at least one capacitive impedance part and the at least one inductive impedance part are connected in series and/or in parallel, and an impedance value of the equivalent impedance part provided by the broadband impedance matching network between the first input port and the second input port changes within a predetermined range.

4. The apparatus according to claim 3, wherein the broadband impedance matching network is an N-order band-pass impedance matching network, and N is an integer greater than 2.

5. The apparatus according to claim 3, wherein the broadband impedance matching network comprises a first impedance matching network, a second impedance matching network, and a third impedance matching network, the first impedance matching network is connected to the 90° directional coupler, the second impedance matching network is connected to the first impedance matching network, and the third impedance matching network is connected to the second impedance matching network;

the first impedance matching network comprises a capacitive impedance part and an inductive impedance part that are connected in parallel, and a resonance frequency of the first impedance matching network is equal to a center frequency of a preset bandwidth;

the second impedance matching network comprises a capacitive impedance part and an inductive impedance part that are connected in series, and a resonance frequency of the second impedance matching network is greater than the center frequency; and

the third impedance matching network comprises a capacitive impedance part and an inductive impedance part that are connected in parallel, and a resonance frequency of the third impedance matching network is equal to any frequency within the preset bandwidth.

6. The apparatus according to claim 1, wherein a phase difference between the first amplified signal and the second amplified signal is 90°.

7. The apparatus according to claim 1, wherein a relative bandwidth of the third amplified signal is greater than or equal to 70%.

8. A signal processing method, applied to a signal processing apparatus, wherein the signal processing apparatus comprises an outphasing amplifier and a combiner matching network, and the method comprises:

in response to a received first signal, amplifying, by the outphasing amplifier, the first signal, and outputting a first amplified signal; and in response to a received second signal, amplifying, by the outphasing amplifier, the second signal, and outputting a second amplified signal, wherein the first amplified signal and the second amplified signal have a same frequency, and there is a phase offset; and

in response to the first amplified signal received by using a first input port and the second amplified signal received by using a second input port, combining, by the combiner matching network, the first amplified signal and the second amplified signal, to obtain a third amplified signal, and outputting the third amplified signal, wherein

the combiner matching network comprises a 90° directional coupler and a broadband impedance matching network, the broadband impedance matching network comprises at least one of a capacitive impedance part and an inductive impedance part, and the broadband impedance matching network provides an adjustable equivalent impedance part between the first input port and the second input port of the 90° directional coupler.

9. The method according to claim 8, wherein the broadband impedance matching network is configured to provide an equivalent impedance part with a corresponding impedance value in a frequency change process of the third amplified signal.

10. The method according to claim 9, wherein the broadband impedance matching network comprises at least one capacitive impedance part and at least one inductive impedance part, the at least one capacitive impedance part and the at least one inductive impedance part are connected in series and/or in parallel, and an impedance value of the equivalent impedance part provided by the broadband impedance matching network between the first input port and the second input port changes within a predetermined range.

11. The method according to claim 10, wherein the broadband impedance matching network is an N-order band-pass impedance matching network, and N is an integer greater than 2.

12. The method according to claim 10, wherein the broadband impedance matching network comprises a first impedance matching network, a second impedance matching network, and a third impedance matching network, the first impedance matching network is connected to the 90° directional coupler, the second impedance matching network is connected to the first impedance matching network, and the third impedance matching network is connected to the second impedance matching network;

the first impedance matching network comprises a capacitive impedance part and an inductive impedance part that are connected in parallel, and a resonance frequency of the first impedance matching network is equal to a center frequency of a preset bandwidth;

the second impedance matching network comprises a capacitive impedance part and an inductive impedance part that are connected in series, and a resonance frequency of the second impedance matching network is greater than the center frequency; and

the third impedance matching network comprises a capacitive impedance part and an inductive impedance part that are connected in parallel, and a resonance frequency of the third impedance matching network is equal to any frequency within the preset bandwidth.

13. The method according to claim 8, wherein a phase difference between the first amplified signal and the second amplified signal is 90°

14. The method according to claim 8, wherein a relative bandwidth of the third amplified signal is greater than or equal to 70%.

15. A chip, comprising a processing circuit and a transceiver pin, wherein the transceiver pin communicates with the processor through an internal connection path, and the processing circuit is configured to perform the method according to any one of claims 8 to 14.

16. A signal processing system, comprising the signal processing apparatus according to any one of claims 1 to 7.

Amplifier

Combiner network

λ/4 transmission line

Isolation resistor

Signal component separator

λ/4 transmission line

FIG. 1

λ/4 transmission line

Signal component separator

$jB_{comp}$

λ/4 transmission line

$-jB_{comp}$

FIG. 2

FIG. 3

| Adjustable capacitor | Adjustable inductor |

FIG. 4

FIG. 5

FIG. 6

1 o———————○ 3

| 0° | OUT |
| 2 o———— 90° | ISO ———————○ 4 |

FIG. 7

Outphasing amplifier 110

Combiner matching network 120

$S_1(t)$

111

$S_{in}(t)$

SCS

$S_2(t)$

112

0°    OUT

90°   ISO

121

$S_{out}(t)$

122

FIG. 8

Outphasing amplifier 110

Combiner matching network 120

$S_1(t)$

111

$S_{in}(t)$

SCS

$S_2(t)$

112

0°    OUT

90°   ISO

121

$S_{out}(t)$

122

FIG. 9

FIG. 10

FIG. 11

FIG. 12

FIG. 13

FIG. 14

FIG. 15

FIG. 16

FIG. 17

EP 4 120 561 A1

Impedance matching network 3

Impedance matching network 2

Impedance matching network 1

L1

C4

L3　C6

L2　C5

FIG. 18

FIG. 19a

FIG. 19b

FIG. 19c

## INTERNATIONAL SEARCH REPORT

| | International application No. |
|---|---|
| | **PCT/CN2021/083610** |

**A. CLASSIFICATION OF SUBJECT MATTER**

H03F 1/18(2006.01)i

According to International Patent Classification (IPC) or to both national classification and IPC

**B. FIELDS SEARCHED**

Minimum documentation searched (classification system followed by classification symbols)

H03F

Documentation searched other than minimum documentation to the extent that such documents are included in the fields searched

Electronic data base consulted during the international search (name of data base and, where practicable, search terms used)

CNPAT, CNKI, WPI, EPODOC: 放大器, 异相, 90度, 正交, 定向, 耦合器, 阻抗, 隔离, 端口, 可调, 多赫蒂, doherty, amplifier, phase, coupler, directional, isolated, isolation, port, adjustable, impedance

**C. DOCUMENTS CONSIDERED TO BE RELEVANT**

| Category* | Citation of document, with indication, where appropriate, of the relevant passages | Relevant to claim No. |
|---|---|---|
| A | CN 1833358 A (ANDREW CO.) 13 September 2006 (2006-09-13) description page 5 last paragraph to page 8 paragraph 3, page 18 last paragraph, figures 3 and 15 | 1-16 |
| A | CN 206211949 U (SUN YAT-SEN UNIVERSITY) 31 May 2017 (2017-05-31) entire document | 1-16 |
| A | CN 107210507 A (SKYWORKS SOLUTIONS, INC.) 26 September 2017 (2017-09-26) entire document | 1-16 |
| A | CN 108123690 A (SUMITOMO ELECTRIC DEVICE INNOVATIONS, INC.) 05 June 2018 (2018-06-05) entire document | 1-16 |
| A | US 2016079650 A1 (INFINEON TECHNOLOGIES AG.) 17 March 2016 (2016-03-17) entire document | 1-16 |

☐ Further documents are listed in the continuation of Box C.    ☑ See patent family annex.

| * | Special categories of cited documents: |
|---|---|
| "A" | document defining the general state of the art which is not considered to be of particular relevance |
| "E" | earlier application or patent but published on or after the international filing date |
| "L" | document which may throw doubts on priority claim(s) or which is cited to establish the publication date of another citation or other special reason (as specified) |
| "O" | document referring to an oral disclosure, use, exhibition or other means |
| "P" | document published prior to the international filing date but later than the priority date claimed |

| "T" | later document published after the international filing date or priority date and not in conflict with the application but cited to understand the principle or theory underlying the invention |
|---|---|
| "X" | document of particular relevance; the claimed invention cannot be considered novel or cannot be considered to involve an inventive step when the document is taken alone |
| "Y" | document of particular relevance; the claimed invention cannot be considered to involve an inventive step when the document is combined with one or more other such documents, such combination being obvious to a person skilled in the art |
| "&" | document member of the same patent family |

| Date of the actual completion of the international search | Date of mailing of the international search report |
|---|---|
| **18 June 2021** | **29 June 2021** |

| Name and mailing address of the ISA/CN | Authorized officer |
|---|---|
| **China National Intellectual Property Administration (ISA/CN)** **No. 6, Xitucheng Road, Jimenqiao, Haidian District, Beijing 100088 China** | |
| Facsimile No. **(86-10)62019451** | Telephone No. |

Form PCT/ISA/210 (second sheet) (January 2015)

<div align="center">

**INTERNATIONAL SEARCH REPORT**
**Information on patent family members**

</div>

| International application No. |
| --- |
| **PCT/CN2021/083610** |

| Patent document cited in search report | | | Publication date (day/month/year) | Patent family member(s) | | | Publication date (day/month/year) |
| --- | --- | --- | --- | --- | --- | --- | --- |
| CN | 1833358 | A | 13 September 2006 | US | 2004189381 | A1 | 30 September 2004 |
|  |  |  |  | US | 2004189380 | A1 | 30 September 2004 |
|  |  |  |  | DE | 602004028227 | D1 | 02 September 2010 |
|  |  |  |  | JP | 2007535828 | A | 06 December 2007 |
| CN | 206211949 | U | 31 May 2017 | | None | | |
| CN | 107210507 | A | 26 September 2017 | JP | 2017537555 | A | 14 December 2017 |
|  |  |  |  | US | 2016172737 | A1 | 16 June 2016 |
|  |  |  |  | US | 2016172740 | A1 | 16 June 2016 |
|  |  |  |  | US | 2016172738 | A1 | 16 June 2016 |
|  |  |  |  | US | 2016172739 | A1 | 16 June 2016 |
|  |  |  |  | KR | 20170093208 | A | 14 August 2017 |
|  |  |  |  | TW | 201633600 | A | 16 September 2016 |
|  |  |  |  | WO | 2016094376 | A2 | 16 June 2016 |
| CN | 108123690 | A | 05 June 2018 | US | 2018152149 | A1 | 31 May 2018 |
|  |  |  |  | JP | 2018093490 | A | 14 June 2018 |
| US | 2016079650 | A1 | 17 March 2016 | DE | 102015115566 | A1 | 17 March 2016 |
|  |  |  |  | CN | 105428773 | A | 23 March 2016 |
|  |  |  |  | KR | 20160031976 | A | 23 March 2016 |

Form PCT/ISA/210 (patent family annex) (January 2015)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- CN 202010281147